Europäisches Patentamt

European Patent Office

Office européen des brevets

(11) Numéro de publication: **0 217 705**
**A1**

## (12) DEMANDE DE BREVET EUROPEEN

(21) Numéro de dépôt: **86402001.1**

(22) Date de dépôt: **12.09.86**

(51) Int. Cl.⁴: **H 05 B 3/22**
**C 30 B 13/18**

(30) Priorité: **18.09.85 FR 8513821**

(43) Date de publication de la demande:
**08.04.87 Bulletin 87/15**

(84) Etats contractants désignés: **DE GB NL**

(71) Demandeur: **COMMISSARIAT A L'ENERGIE ATOMIQUE**
**31/33, rue de la Fédération**
**F-75015 Paris (FR)**

(72) Inventeur: **Bechevet, Bernard**
**Lotissement La Cascade Cédex 334**
**F-38640 Claix (FR)**

**Calvat, Claude**
**40 route de Grenoble Les Moutonnées**
**F-38120 Saint Egreve (FR)**

**Hugot, Philippe**
**13, Résidence Charvinière**
**F-38330 Saint Ismier (FR)**

**Basset, Gérard**
**44, Route de Grenoble Les Moutonnées**
**F-38120 Saint Egreve (FR)**

(74) Mandataire: **Mongrédien, André et al**
**c/o BREVATOME 25, rue de Ponthieu**
**F-75008 Paris (FR)**

(54) **Resistor pour le traitement de matériaux.**

㉗ Resistor comprenant une plaque (16) mince, électriquement conductrice, et comportant une zone percée d'une pluralité de trous (6). La plaque a, vis-à-vis d'un courant électrique se propageant dans cette plaque sensiblement parallèlement aux faces de ladite plaque, une résistance électrique plus faible dans un domaine périphérique (4) de ladite zone que dans la partie centrale (5) de cette zone.

Application à l'élaboration de monocristaux par la méthode du résistor plan.

FIG. 1

# Description

## RESISTOR POUR LE TRAITEMENT DE MATERIAUX

La présente invention concerne un résistor pour le traitement de matériaux.

On sait qu'un résistor comprend une plaque mince, électriquement conductrice, qui comporte une zone percée d'une pluralité de trous et qui est utilisé pour traiter des matériaux, en particulier pour élaborer un monocristal à partir d'un matériau polycristallin ou pour purifier un matériau par fusion de zone.

On connaît déjà, par les brevets FR-A-2 067 923, FR-A-2 251 368 et GB-A-1 059 916, de tels résistors, mais on a constaté que les résistors décrits dans ces documents ne permettent pas de traiter convenablement les matériaux et ne permettent notamment pas d'élaborer des cristaux de gros diamètres, de grande longueur et de bonne qualité.

La présente invention a pour but de remédier à cet inconvénient.

Elle a pour objet un résistor pour le traitement de matériaux, comprenant une plaque mince, électriquement conductrice, qui comporte une zone percée d'une pluralité de trous, caractérisé en ce que la plaque a, vis-à-vis d'un courant électrique se propageant dans cette plaque, sensiblement parallèlement aux faces de ladite plaque, une résistance électrique plus faible dans un domaine périphérique de ladite zone que dans la partie centrale de cette zone.

L'inhomogénéité de résistance électrique présentée par la plaque a pour effet d'augmenter la densité de courant et donc la puissance dégagée ainsi que la température, dans ledit domaine (par rapport à la partie centrale de la zone). Le gradient thermique particulier ainsi créé par la plaque lorsqu'elle est chauffée, permet d'effectuer un meilleur traitement des matériaux que dans l'art antérieur rappelé ci-dessus. En particulier, l'invention permet de fabriquer des cristaux de plus grand diamètre, de plus grande longueur et de meilleur equalité, ces trois paramètres étant en effet liés au gradient thermique en question.

Selon un mode de réalisation particulier du résistor objet de l'invention, la plaque a une épaisseur plus grande dans ledit domaine que dans la partie centrale de la zone.

Dans une réalisation particulière, la plaque comprend une première lame mince et une seconde lame mince en forme de couronne, rapportée sur la première lame, cette première lame est percée de trous dans la partie délimitée par la phériphérie de la couronne et ceux des trous qui sont situés dans la partie couverte par la couronne traversent également celle-ci.

De préférence, la couronne est pourvue de deux prolongements qui s'étendent suivant un même diamètre de la couronne, de part et d'autre de celle-ci, ont une largeur, comptée transversalement à ce diamètre, qui diminue en allant vers la couronne, et sont également rapportés sur la première lame, la plaque étant destinée à être chauffée par un courant électrique circulant dans la plaque, sensiblement suivant une direction allant d'un prolongement vers l'autre.

Cette forme particulière des prolongements permet de réduire fortement, voire de supprimer, les surchauffes au bord du résistor.

Selon un autre mode de réalisation particulier du résistor objet de l'invention, la plaque a une densité de matière plus grande dans ledit domaine que dans la partie centrale de la zone.

Pour ce faire, dans une première réalisation particulière, la taille des trous est plus grande dans la partie centrale de ladite zone que dans ledit domaine et, dans une seconde réalisation particulière, la densité surfacique des trous est plus grande dans la partie centrale de ladite zone que dans ledit domaine.

Bien entendu, la première et la seconde réalisations peuvent être combinées. A titre d'exemple, la taille des trous et/ou la densité surfacique de ces trous peuvent diminuer du centre à la périphérie de la zone.

Enfin, en ce qui concerne l'autre mode de réalisation particulier, la plaque peut être pourvue, sur au moins l'une de ses faces, de réflecteurs thermiques opposés par rapport à ladite zone et adjacents à celle-ci, la plaque étant destinée à être chauffée au courant électrique circulant dans la plaque sensiblement suivant une direction allant d'un réflecteur vers l'autre.

Les réflecteurs peuvent donc être présents sur une seule face (supérieure ou inférieure) de la plaque. Ils peuvent également être présents sur les deux faces de la plaque, ce qui est souhaitable afin d'homogénéiser les températures, dans le cas de l'élaboration de lingots cristallins de diamètre important.

La présente invention sera mieux comprise à la lecture de la description qui suit, d'exemples de réalisation donnés à titre purement indicatif et nullement limitatif, en référence aux dessins annexés sur lesquels :

- la figure 1 est une vue schématique d'un mode de réalisation particulier du résistor objet de l'invention,
- la figure 2 illustre schématiquement le tirage d'un monocristal au moyen de ce résistor,
- la figure 3 représente la courbe des variations radiales de température dans la zone de cristallisation, au niveau de la plaque, en cours de tirage,
- la figure 4 est une vue schématique d'un autre mode de réalisation particulier du résistor objet de l'invention,
- la figure 5 illustre la répartition des trous du résistor représenté sur la figure 4,
- la figure 6 illustre une autre répartition possible pour ces trous, et
- la figure 7 illustre schématiquement le tirage d'un monocristal au moyen du résistor représenté sur la figure 4.

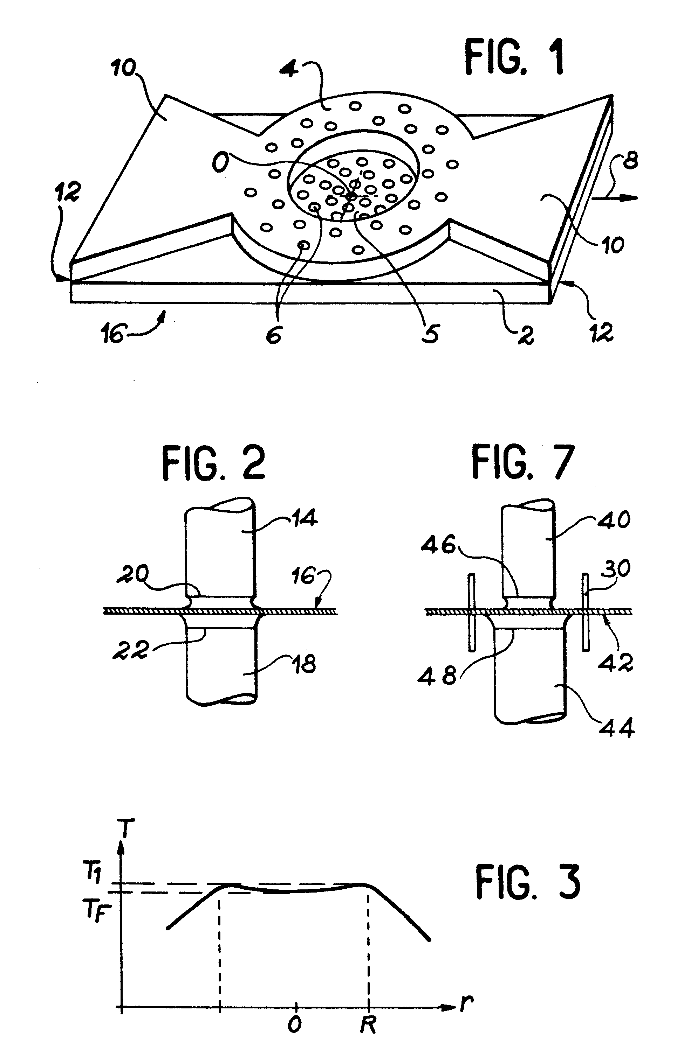

Sur la figure 1, on a représenté schématiquement un mode de réalisation particulier du résistor objet de l'invention. Ce mode de réalisation particulier comporte une première lame mince 2 électriquement conductrice, de forme allongée, par exemple de forme rectangulaire ainsi qu'une seconde lame 4 électriquement conductrice, en forme de couronne, rapportée sur la première lame 2 et disposée au centre de celle-ci. Une pluralité de trous 6 sont répartis sur la couronne 4 et traversent celle-ci ainsi que la partie de la première lame 2 située au-dessous de la couronne. La partie 5 de la première lame 2 qui est entourée par la couronne 4, est également traversée par des trous 6. De préférence, la répartition des trous 6 est régulière.

Le résistor représenté sur la figure 1 est destiné à être chauffé par un courant électrique qui parcourt ce résistor suivant la longueur de la plaque 2, dans la direction et le sens qui sont représentés par la flèche référencée 8 sur la figure 1. Dans une réalisation préférée, afin d'éviter toute surchauffe sur les bords du résistor, la couronne 4 est pourvue de deux prolongements 10 (en forme de lames minces électriquement conductrices) qui s'étendent de part et d'autre de la couronne, suivant la direction longitudinale de la première plaque 2, et ont une largeur, comptée transversalement à cette direction, qui diminue en allant vers la couronne 4, chaque prolongement 10 s'étendant jusqu'au bord 12 de la première plaque 2. Chacun de ces prolongements a par exemple la forme d'un trapèze isocèle.

L'ensemble couronne 4-prolongements 10 est par exemple fixé à la première plaque 2 par soudage.

L'épaisseur de la couronne 4 et l'épaisseur de chaque prolongement 10 sont par exemple égales à l'épaisseur de la plaque 2.

Cette plaque 2 ainsi que ledit ensemble 4, sont par exemple réalisés en platine.

Le résistor représenté sur la figure 1 est par exemple utilisable pour l'élaboration d'un monocristal de $LiNbO_3$ dont la température de fusion $T_F$ est égale à 1250°C. Le monocristal est élaboré au moyen d'une charge cylindrique 14 (figure 2) de diamètre au plus égal au diamètre de la couronne 4 et située au-dessus du résistor 16 représenté sur la figure 1, l'axe de la charge passant par le centre O de la couronne, et au moyen d'un germe non représenté, qui est situé au-dessous du résistor. Celui-ci est porté à une température légèrement supérieure à $T_F$ tandis que la charge 14 et le germe, qui sont initialement au contact du résistor, et fondent donc à son contact, sont descendus suivant l'axe de la couronne. Le monocristal 18 se forme ainsi au-dessous du résistor 16. Avec celui-ci, l'interface de fusion 20, située légè rement au-dessus de ce résistor et l'interface de croissance 22 située légèrement au-dessous dudit résistor sont sensiblement planes.

A titre purement indicatif et nullement limitatif, le résistor 16 a une largeur de 40 mm et une longueur de 120 mm, l'épaisseur de la première lame 2 et l'épaisseur de la seconde lame 4 et des prolongements 10 de celle-ci est de 0,1 mm, le diamètre intérieur de la couronne 4 est de 20 mm et le diamètre extérieur de cette couronne est de 40 mm. Les trous ont un diamètre de 1 mm et sont répartis régulièrement suivant deux directions perpendiculaires, avec un pas de trois millimètres, sur toute la surface (zone de cristallisation) délimitée par la périphérie de la couronne, de diamètre extérieur 40 mm.

Le résistor ainsi constitué permet d'élaborer des monocristaux de $LiNbO_3$ de l'ordre de 20 à 40 mm de diamètre et de l'ordre de 30 à 70 millimètres de longueur, ces monocristaux étant orientés suivant la direction cristallographique z.

La charge de départ a par exemple un diamètre de 28 mm et peut être constituée d'une poudre de $LiNbO_3$ pressée isostatiquement et densifiée à environ 65%.

Sur la figure 3, on a représenté les variations de la température T au niveau du résistor 16, en fonction de la distance r au centre O de la couronne 4 dont le rayon extérieur est référencé R. On voit sur cette figure 3 que le gradient thermique radial est sensiblement nul dans la zone de cristallisation, de diamètre 2R, la température maximale $T_1$ dans cette zone excédant $T_F$ d'environ 20°C, l'intensité maximale du courant circulant dans le résistor étant de l'ordre de 200A, pour une tension de l'ordre de 1 à 2 volts, établie entre les extrémités 12 dudit résistor.

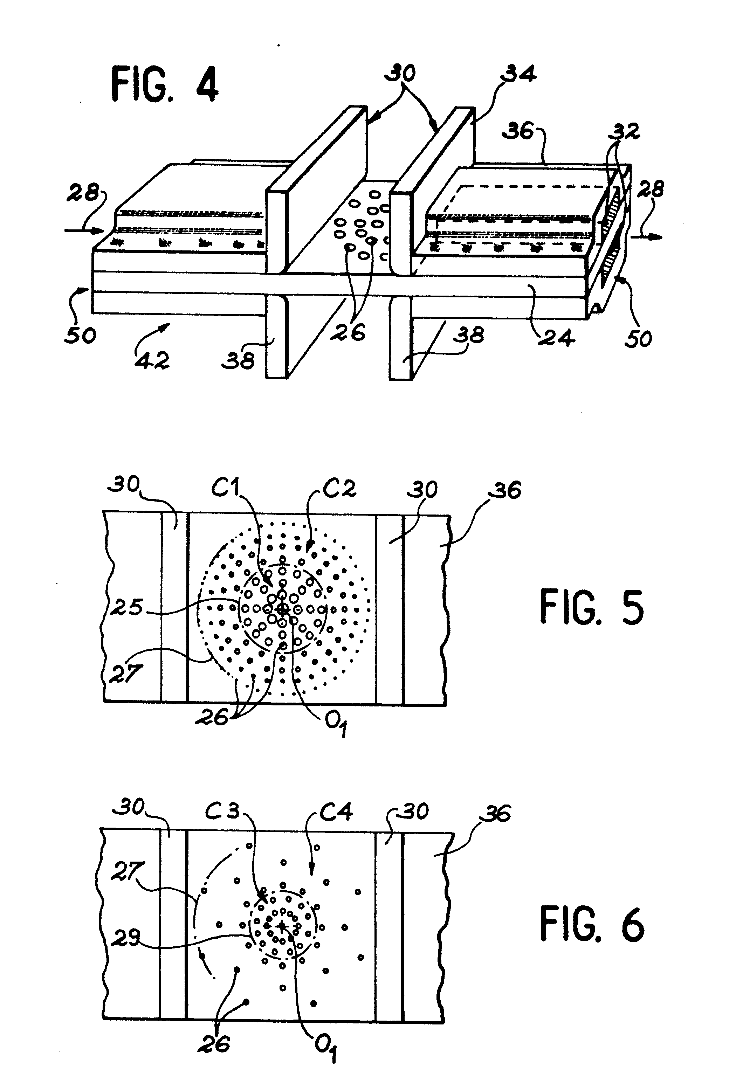

Sur la figure 4, on a représenté schématiquement un autre mode de réalisation particulier du résistor objet de l'invention, notamment utilisable pour l'élaboration de monocristaux de $Nd_3Ga_5O_{12}$, de $Sm_3Ga_5O_{12}$ ou de $Gd_3Ga_5O_{12}$, la température de fusion élevée de ces matériaux rendant souhaitable l'utilisation de réflecteurs (dont il sera question par la suite) pour leur élaboration.

Le résistor schématiquement représenté sur la figure 4, comprend une lame mince 24 de forme allongée, par exemple rectangulaire, électriquement conductrice. Cette lame est percée d'une pluralité de trous 26 répartis, de préférence régulièrement, sur une zone circulaire de la partie centrale de la lame 24. Le résistor de la figure 4 est destiné à être chauffé par un courant électrique se propageant suivant la longueur de la lame 24, dans la direction et le sens définis par les flèches 28 de la figure 4.

Deux réflecteurs thermiques 30, faits d'un matériau électriquement conducteur, s'étendent sur une face de la lame 24, de part et d'autre de la zone des trous 26. Chaque réflecteur 30 est par exemple constitué d'une plaque coudée à angle droit dont un côté 32, moins large que la lame 24, repose contre celle-ci, tandis que l'autre côté 34, le plus proche de la zone des trous 26, s'élève perpendiculairement à la lame 24 sur toute la largeur de celle-ci. Le réflecteur 30 est fixé à la lame 24 au moyen d'une feuille métallique 36 qui recouvre le côté 32 et dont les bords reposent contre la lame 24. La feuille 36 est de plus fixée au côté 32 et à la lame 24 par exemple par soudure par point.

A titre purement indicatif et nullement limitatif, la lame 24 et chaque réflecteur 30 sont en iridium et chaque feuille 36 est en platine, ce qui facilite sa soudure au réflecteur 30 et à la lame 24.

Des réflecteurs 38, identiques aux réflecteurs 30, sont disposés sur l'autre face de la lame 24 symétriquement aux réflecteurs 30.

La répartition des trous 26 peut être symétrique par rapport au centre $O_1$ de la zone comportant ces trous. Le diamètre des trous 26 peut décroître

progressivement du centre $O_1$ jusqu'à la périphérie de la zone des trous 26 (figure 5) ou les trous 26 peuvent avoir tous le même diamètre et une densité surfacique qui décroît à partir du centre $O_1$ (figure 6).

On peut réaliser des trous d'un diamètre déterminé $D_1$, rangés suivant un pas déterminé $P_1$, à l'intérieur de la surface $C_1$ d'un cercle 25 de centre $O_1$. Sur la surface $C_2$ de l'anneau compris entre le cercle 27, délimitant la zone des trous, et le cercle 25, des trous de diamètre $D_2$ inférieur à $D_1$, sont rangés suivant un pas $P_2$ inférieur à $P_1$ (voir figure 5). Par exemple, l'anneau a un diamètre extérieur égal au double de son diamètre intérieur.

On peut également réaliser des trous d'un diamètre déterminé $D_3$ rangés suivant un pas déterminé $P_3$ à l'intérieur de la surface $C_3$ d'un cercle 29 de centre $O_1$. Sur la surface $C_4$ de l'anneau compris entre le cercle 27 et le cercle 29, les trous de diamètre $D_3$ sont rangés suivant un pas $P_4$ supérieur à $P_3$ (voir figure 6).

Le résistor de la figure 4 peut être utilisé pour élaborer des monocristaux de $Nd_3Ga_5O_{12}$ dont la température de fusion est de 1515° C. L'élaboration s'effectue comme on l'a indiqué dans la description de la figure 2, au moyen d'une charge 40 (figure 7) qui traverse le résistor 42 décrit en référence à la figure 4, porté à une température appropriée légèrement supérieure à la température de fusion, pour donner un monocristal 44. Grâce au résistor 42, l'interface de fusion 46 et l'interface de croissance 48 sont sensiblement planes.

A titre purement indicatif et nullement limitatif, la largeur du résistor est de 40 mm et la longueur de ce résistor est de 120 mm. L'épaisseur de la lame 24 est de 0,15 mm, l'épaisseur de chaque plaque 30 est de 0,15 mm et l'épaisseur de la feuille 36 est de 0,1 mm. La longueur totale des parties 32 et 34 est de 42 mm et la hauteur du côté 34 de la plaque 30, constituant le réflecteur proprement dit, est de 7 mm. La largeur de la plaque 30 est de 40 mm sur le côté 34 et de 20 mm sur le côté 32. La largeur de la feuille 36 est de 40 mm et la longueur de cette feuille 36 est de 41 mm. Les trous 26 ont un diamètre de 1,5 mm et sont répartis suivant un pas de 3 mm sur la surface d'un cercle de centre $O_1$ et de diamètre 20 mm tandis que sur le reste de la zone, les trous 26 ont un diamètre de 1 mm et présentent entre eux un pas de 3 mm.

A partir d'une charge initiale de forme cylindrique de 18 mm de diamètre, constituée d'un mélange de $Nd_2O_3$, $Gd_2O_3$ pressé isostatiquement, et pour un courant électrique d'intensité 350A et une tension électrique comprise entre 1 et 3 volts, établie entre les extrémités 50 du résistor 42, on peut obtenir des monocristaux de $Nd_3Ga_5O_{12}$ de 25 mm de diamètre et de 30 mm de long, ayant une orientation cristallographique <111>.

Au lieu de l'iridium ou du platine, on pourrait utiliser le nickel, l'acier inoxydable ou le graphite pour réaliser les lames 2, 4, 10 et 26.

## Revendications

1. Résistor pour le traitement de matériaux, comprenant une plaque mince (16, 42), électriquement conductrice, qui comporte une zone percée d'une pluralité de trous (6, 26), caractérisé en ce que la plaque a, vis-à-vis d'un courant électrique se propageant, dans cette plaque, sensiblement parallèlement aux faces de ladite plaque, une résistance électrique plus faible dans un domaine périphérique (4, $C_2$, $C_4$) de ladite zone que dans la partie centrale (5, $C_1$, $C_3$) de cette zone.

2. Résistor selon la revendication 1, caractérisé en ce que la plaque (16) a une épaisseur plus grande dans ledit domaine (4) que dans la partie centrale (5) de la zone.

3. Résistor selon la revendication 2, caractérisé en ce que la plaque (16) comprend une première lame mince (2) et une seconde lame mince en forme de couronne (4), rapportée sur la première lame, en ce que cette première lame est percée de trous (6) dans la partie délimitée par la périphérie de la couronne et en ce que ceux des trous qui sont situés dans la partie couverte par la couronne traversent également celle-ci.

4. Résistor selon la revendication 3, caractérisé en ce que la couronne (4) est pourvue de deux prolongements (10) qui s'étendent suivant un même diamètre de la couronne, de part et d'autre de celle-ci, ont une largeur, comptée transversalement à ce diamètre, qui diminue en allant vers la couronne, et sont également rapportés sur la première lame (2), la plaque étant destinée à être chauffée par un courant électrique circulant dans la plaque sensiblement suivant une direction allant d'un prolongement vers l'autre.

5. Résistor selon la revendication 1, caractérisé en ce que, la plaque (42) a une densité de matière plus grande dans ledit domaine ($C_2$, $C_4$) que dans la partie centrale ($C_1$, $C_3$) de la zone.

6. Résistor selon la revendication 5, caractérisé en ce que la taille des trous est plus grande dans la partie centrale ($C_1$) de ladite zone que dans ledit domaine ($C_2$).

7. Résistor selon la revendication 5, caractérisé en ce que la densité surfacique des trous est plus grande dans la partie centrale ($C_3$) de ladite zone que dans ledit domaine ($C_4$).

8. Résistor selon l'une quelconque des revendications 5 à 7, caractérisé en ce que la plaque (42) est pourvue, sur au moins l'une de ses faces, de réflecteurs thermiques (30) opposés par rapport à ladite zone et adjacents à celle-ci, la plaque étant destinée à être chauffée par un courant électrique circulant dans la plaque sensiblement suivant une direction allant d'un réflecteur vers l'autre.

**FIG. 1**

**FIG. 2**

**FIG. 7**

**FIG. 3**

FIG. 4

FIG. 5

FIG. 6

**Office européen des brevets**

## RAPPORT DE RECHERCHE EUROPEENNE

Numéro de la demande

EP 86 40 2001

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.⁴) |
|---|---|---|---|
| A | FR-A-2 441 004 (HITACHI) <br> * Page 12, lignes 13-32; figure 1 * | 1,7 | H 05 B 3/22 <br> C 30 B 13/18 |
| A | US-A-3 351 742 (HARRIS) <br><br> * Colonne 3, ligne 41 - colonne 4, ligne 9; figures 1,3 * | 1,2,4, 7 | |
| A | FR-A-2 373 206 (A.N.V.A.R.) <br><br> * Page 6, lignes 3-34; figures 2A,3 * | 1,2,4, 5 | |
| A | GB-A-1 142 935 (U.K. ATOMIC ENERGY AUTHORITY) <br> * Page 2, lignes 1-14; figure 2 * | 8 | |
| A | GB-A-2 109 911 (U.S.A.) | | |
| A | FR-A-2 138 232 (L.E.P.) | | |
| A | US-A-4 152 572 (NODA et al.) | | |

**DOMAINES TECHNIQUES RECHERCHES (Int. Cl.⁴)**

H 05 B 3/00
C 30 B 13/00

Le présent rapport de recherche a été établi pour toutes les revendications

| Lieu de la recherche | Date d'achèvement de la recherche | Examinateur |
|---|---|---|
| LA HAYE | 09-12-1986 | RAUSCHER |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82